# EUROPÄISCHE PATENTSCHRIFT

(11) **EP 1 348 323 B1**
(45) Veröffentlichungstag und Bekanntmachung des Hinweises auf die Patenterteilung: **03.01.2007**
(21) Anmeldenummer: 01271985.2
(22) Anmeldetag: 27.11.2001
(51) Int. Cl.: H05K 9/00

(54) **VERFAHREN ZUR HERSTELLUNG EINER ABSCHIRMDICHTUNG**
METHOD FOR PRODUCING A SHIELD GASKET
PROCEDE DE PRODUCTION D'UNE GARNITURE DE BLINDAGE

(30) Priorität: 23.12.2000 DE 10064968
(43) Veröffentlichungstag der Anmeldung: 01.10.2003
(73) Patentinhaber: Kahl, Helmut, 12307 Berlin (DE); Tiburtius, Bernd, 14532 Kleinmachnow (DE)
(72) Erfinder: Kahl, Helmut, 12307 Berlin (DE); Tiburtius, Bernd, 14532 Kleinmachnow (DE)
(74) Vertreter: Keussen, Christof
(86) Internationale Anmeldenummer: PCT/EP2001/013777
(87) Internationale Veröffentlichungsnummer: WO 2002/052913

(56) Entgegenhaltungen:
- WO-A-98/08364
- US-A- 5 246 974
- US-A- 6 096 413

## Beschreibung

Die Erfindung betrifft ein Verfahren zur Herstellung einer elektromagnetischen Abschirmdichtung.

Elektromagnetische Abschirmdichtungen sowie Verfahren zu ihrer Herstellung sind bereits seit langem bekannt. Hierbei sei auch auf die verschiedenen Anmeldungen der vorliegenden Anmelderin sowie die in den Prüfungsverfahren zu diesen Anmeldungen zitierten Druckschriften verwiesen.

Ferner sei auch verwiesen auf die europäische Patentanmeldung EP 0 779 629 A2. Diese Anmeldung beschreibt einen elektrisch leitenden Komposit-Artikel, welcher eine Polytetrafluorethylen-Matrix sowie elektrisch leitende Teile, elektrisch nicht leitende Teile und weitere unter Wärmeeinfluss expandierbare hohlpolymerische Teile aufweist. Dort ist auch beschrieben, dass der elektrisch leitende Komposit-Artikel auch ein elastomerisches Material enthalten soll, wobei es sich bei dem elastomeren Material um ein Silikon-Material handeln kann. Aus der vorgenannten Druckschrift ist zwar bekannt, den dort beschriebenen und beanspruchten Artikel zur Herstellung einer elektromagnetischen Abschirmdichtung einzusetzen, allerdings ist es mit dem in EP 0 779 629 A2 beschriebenen Gegenstand sehr schwierig, eine Abschirmdichtung herzustellen, insbesondere dann, wenn die äußeren Abmaße der Abschirmdichtung nur äußerst gering sein dürfen, beispielsweise im Bereich eines Durchmessers von wenigen mm liegen.

Der Erfindung liegt die Aufgabe zugrunde, die Nachteile der Abschirmdichtung bzw. ihrer Herstellung, wie sie aus EP 0 779 629 A2 bekannt ist, zu vermeiden.

Die Aufgabe wird erfindungsgemäß mit einem Verfahren nach Anspruch 1 sowie einem elektrischen Gerät mit einer entsprechenden Abschirmdichtung nach Anspruch 6 gelöst. Vorteilhafte Weiterbildungen sind in den Unteransprüchen beschrieben.

Der wesentliche Unterschied zwischen der vorliegenden Erfindung und dem Stand der Technik nach EP 0 779 629 A2 liegt darin, dass bei der Erfindung keine Polytetrafluorethylen-Matrix zum Aufbau der Abschirmdichtung notwendig ist. Vielmehr wird die elektrische Abschirmdichtung durch Dispensieren einer Abschirmmasse und einer anschließenden Wärmebehandlung der dispensierten Masse hergestellt, wobei die Wärmebehandlung solange stattfindet, bis die dispensierte Masse ihre vorbestimmte Ausweitung bzw. Form erhält. Die Abschirmmasse enthält elektrisch leitfähige Teile, zum Beispiel Silberpartikel, Kohle, Metallpulver usw. sowie expandierbare Teile, vorzugsweise expandierbare polymerische Hohlkugeln sowie Silikonkunststoff.

Die Herstellung einer dispensierten Abschirmdichtung ist erheblich günstiger und einfacher durchzuführen als die Herstellung einer Abschirmdichtung wie sie aus EP 0 779 629 A2 bekannt ist.

Bei dem erfindungsgemäßen Verfahren können Dispensgeräte zum Dispensauftrag der Abschirmmasse verwendet werden und nach dem Dispensieren kann die Wärmebehandlung entweder direkt während des Dispensvorganges oder im Anschluss daran in einer Wärmekammer erfolgen.

Die Mikrohohlkugeln können beispielsweise solche sein, wie sie von der Firma Nobel Industries aus Sundsvall, Schweden, unter dem Markennamen "..." erhältlich sind. Solche Mikrohohlkugeln können in einer großen Variabilität von Größe und Form erhalten werden mit einer Ausdehnungs(Expansions)- Temperatur, die im wesentlichen zwischen 70 und 130°C liegt. Eine typische ...-Mikrohohlkugel hat einen Anfangsdurchschnittsdurchmesser (noch nicht ausgedehnt) von 9 bis 17 µm und im Durchschnitt einen expandierten Durchmesser von 40 bis 60 µm. Demgemäß liegt das Kubikmetergewicht der Mikrohohlkugeln im unexpandierten Zustand bei etwa 1250 bis 1300 kg/m³, im expandierten Zustand bei etwa 20 bis 30 kg/m³.

Insbesondere wenn die Wärmebehandlung beim Dispensvorgang der Abschirmmasse oder kurz danach erfolgt, ist es möglich, eine große Anzahl von Abschirmdichtungen innerhalb von kürzester Zeit auf einfache Art und Weise herzustellen, wobei gerade der Dispensroboter, mit dem die Abschirmmasse auf ein Gehäuse, eine Leiterplatte oder ein Gehäuseteil aufgetragen wird, den Dispensauftrag den jeweiligen Anforderungen an die Gehäusegeometrie leicht anpassen kann. Auch können solche Dispensgeräte in einfacher Art und Weise mit einer Wärme erzeugenden Einrichtung versehen werden, beispielsweise einer Infrarotstrahlungseinheit oder einem Laser oder einer anderen Einrichtung zur Wärmeerzeugung, so dass sich die expandierbaren Mikrohohlkugeln ausdehnen können.

Die Wärmebehandlung dauert je nachdem, wie weit sich die dispensierte Abschirmmasse ausdehnen soll und welche Form sie hierbei annehmen muss.

Nach der Wärmebehandlung ist der Durchmesser der zum Beispiel als Raupe (oder Raupen) aufgetragenen Abschirmmasse deutlich größer als vor der Wärmebehandlung. Die Durchmesserausdehnung bzw. Aufweitung des Durchmessers kann durch die Temperatur bzw. Zeitdauer der Wärmebehandlung so eingestellt werden, dass die Expansion das gewünschte Maß erreicht.

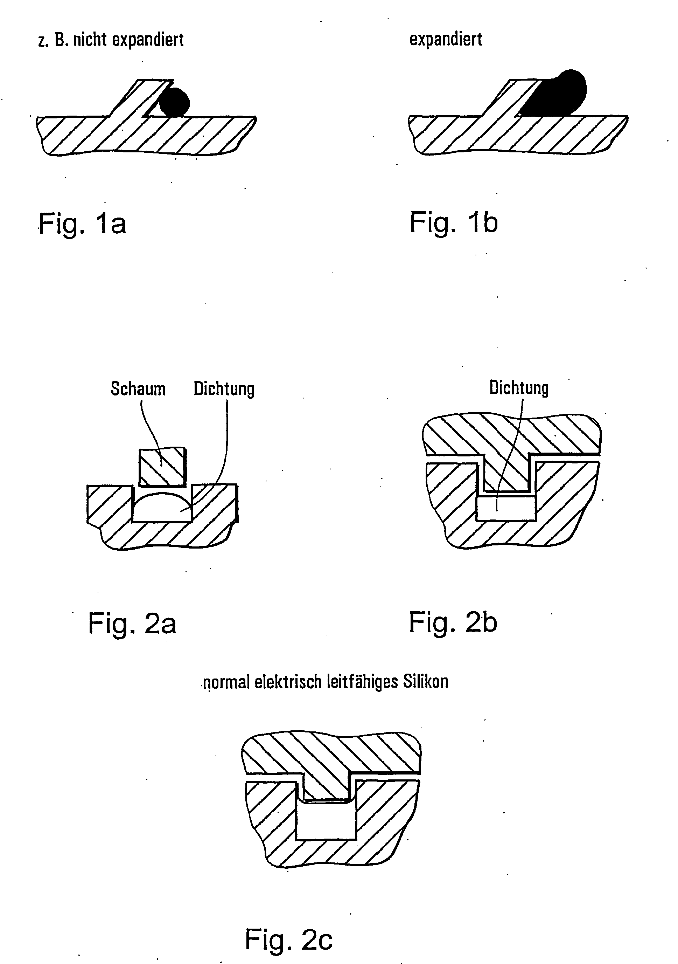

Insbesondere dann, wenn mit einer üblichen dispensierten Raupe der Dispensauftrag nicht ausreicht, weil beispielsweise die dispensierte Raupe den Abstand zweier Gehäuseteile zueinander nicht vollständig überbrücken kann, ist der Einsatz der erfindungsgemäßen Lösung sehr zweckmäßig und kostengünstig. Die erfindungsgemäße Dichtung ist insbesondere für Wasserdichtigkeit, sei es Spritzwasser oder auch Druckwasser, geeignet. Auch ist es möglich sogenannte "Leitwände" aufzubauen, d.h. dass Stege, Flansche so ausgelegt werden, dass wenn eine Expandierung geschieht, die Richtung und/oder Form annähernd vorbestimmt wird. Dies ist beispielsweise in Fig. 1, 2, 3 und 6 dargestellt.

Der Anteil des Silikon(kautschuks) in der Abschirmmasse kann im Bereich von 20 bis 70% liegen, der Anteil der elektrisch leitenden Teile im Bereich von 20 Vol.-% - 80% (je nach Füllstoff) des Ausgangsmaterials sowie der Anteil der Mikrohohlkugeln im Bereich von etwa 1 bis 25 Vol.-% des Ausgangsmaterials liegen.

Nach der Wärmebehandlung beträgt der Härtegrad der erfindungsgemäßen Abschirmdichtung nach Shore A etwa 15 bis 85, wobei der geeignete Härtegrad durch Auswahl eines entsprechenden Kunststoffs oder Dauer der Wärmebehandlung bestimmt werden kann.

Der absolute Durchmesser der Abschirmdichtung kann im Bereich von weniger als 1 mm bis zu 30 mm liegen.

Die Wärmebehandlung zur Ausdehnung der gesamten Abschirmmasse aufgrund der gleichzeitigen Ausdehnung der Mikrohohlkugeln kann auch nach dem Dispensieren der Abschirmmasse und nach dem Zusammensetzen der Gehäuse, zum Beispiel in einem Heizofen, erfolgen. Da die Temperaturen der Wärmebehandlung noch relativ gering liegen und regelmäßig keine Zerstörung des Gehäuses bzw. Gehäuseteiles nach sich ziehen, führt eine solche Behandlung des bereits zusammengesetzten Gehäuses dann dazu, dass durch die Ausdehnung der Abschirmmasse sich diese exakt im gesamten Gehäuse bzw. im Spalt zwischen den aufeinandergesetzten Gehäuseteilen verteilt und diese so abschließt und abdichtet, dass keine elektromagnetischen Strahlen mehr in das Gehäuse eindringen oder aus diesem heraustreten können. Auch wird gleichzeitig eine hervorragende mechanische Abdichtung gegenüber Feuchtigkeit, Flüssigkeit oder anderen Gegenständen, wie zum Beispiel Staub, erreicht.

Auch nach dem Expandiervorgang ist die Abschirmdichtung nach wie vor noch elastisch und selbst mehrfaches Öffnen und Schließen der Gehäuse und das Wiederaufeinandersetzen von Gehäuseteilen ist ohne weiteres möglich, ohne dass die entsprechende Abschirmmasse hierbei Schaden nimmt bzw. die Funktionsfähigkeit der Abschirmdichtung wesentlich beeinflusst wird.

Die in der vorliegenden Anmeldung beschriebene Wärmebehandlung kann durch eine beheizte Nadel aber auch Düse durchgeführt werden oder, wenn die Dichtung bereits auf einem Teil liegt, kann auch eine einfache Wärmenachbehandlung durchgeführt werden. Es ist auch möglich mit dem erfindungsgemäßen Verfahren einen elektrisch leitfähigen Schaum herzustellen, der beispielsweise auf eine Folie aufdispensiert werden kann.

Der wesentliche Unterschied zwischen dem erfindungsgemäßen Verfahren und dem Vorschlag nach EP 0 779 629 - Figur 4 - liegt auch darin, dass das bekannte Fertigungsverfahren nach EP 0 779 629 sechs Fertigungsschritte bedarf und daher sehr aufwendig ist. Die sechs Fertigungsschritte sind im Wesentlichen trocknen (nach dem Mischen), einfrieren, zermahlen, extrudieren, stanzen und dann applizieren auf eine Folie, z.B. auf ein Telefonteil. Beim erfindungsgemäßen Verfahren hingegen bedarf es nur den Fertigungsschritten mischen, auftragen, expandieren.

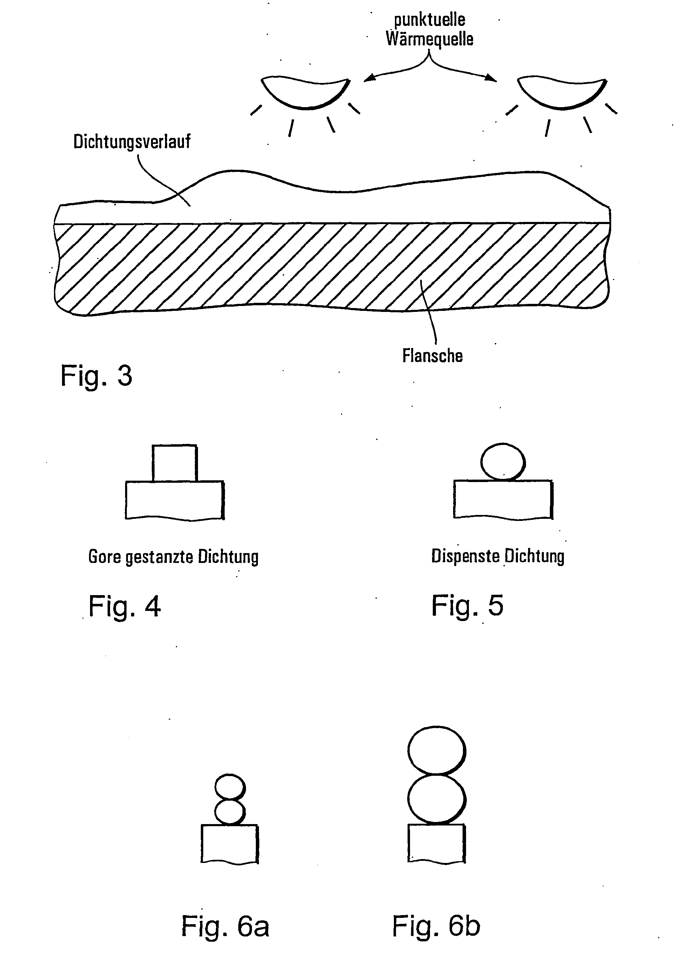

Gegenüber PTFE - wie in EP 0 779 629 offenbart, hat Silikon einen erheblich besseren Kompressions-Set-Wert. Allgemein sind auch dispenste Dichtungen - Figur 5 - kleiner in den Anpresskräften, die zur Verformung notwendig sind.

Während gemäß der Entgegenhaltung EP 0 779 629 Silikon-Polymere als Beimengung zu der PTFE(Polytetrafluorethylen)-Masse beschrieben sind, wobei die elektrisch leitenden PTFE-Zusammensetzungen, die auch ein Elastomer enthalten, zur Herstellung die einzelnen Komponenten gemixt, getrocknet (auf 105° C für 24 Stunden) und/oder tiefgefroren (-10° Celsius für 6 Stunden) gesiebt, verdünnt, bei Raumtemperatur gelagert, extrudiert, getrocknet und expandiert werden, ist bei dem erfindungsgemäßen Prozess lediglich ein Mixen und Abfüllen der erfindungsgemäßen Komponenten der Dichtung in Kartuschen ausreichend und danach kann eine Applizierung der Dichtung beispielsweise mittels Dispensen über Nadeln und Düsen erfolgen. Die Expansion der Abschirmmasse durch Wärme kann entweder durch die Erwärmung der Nadel (Düse) selbst erfolgen oder die Wärme wird nach dem Auftragen der Dichtung aufgebracht.

Bei dem erfindungsgemäßen Verfahren liegt bevorzugt nach dem Dispensen eine im Querschnitt halbrunde Dichtung vor, was die Kraft, die benötigt wird, um die Dichtung dann später zu verformen, verringert.

Wichtig ist auch die Feststellung, dass bei dem erfindungsgemäßen Verfahren die endgültige Form der Dichtung ganz wesentlich durch die Art und/oder Menge der aufgebrachten Wärme bestimmt wird. Im Unterschied dazu ist aus der WO 98/08365 ein Verfahren bekannt, bei welchem die endgültige Dichtungsform (insbesondere hinsichtlich ihres Querschnitts) bevorzugt durch den Nadeldurchmesser (Düsendurchmesser), die Auftragsgeschwindigkeit oder durch die Zusammensetzung des Compounds (Viskosität, Thixotropie etc.) bzw. durch die Auftragsausrüstung bestimmt wird. Auch war es zwar schon zuvor bekannt, generell auch Dichtungen nach ihrem Auftrag mit Wärme zu behandeln, diese Wärmebehandlung dient jedoch allein dem Zweck der Vernetzung, Trocknung oder Härtung der Silikonpolymere, hatte jedoch nichts mit der konkreten Bildung der Querschnittsformen der Dichtungen zu tun. Die Bestimmung der Ausweitung und/oder Form der Abschirmdichtung abhängig vom konkreten Wärmeauftrag ist die besondere Kenntnis der vorliegenden Erfindung und erleichtert in bestimmten Einsatzformen die Herstellung einer elektromagnetischen Abschirmdichtung bzw. macht sie gegenüber bekannten Lösungen kostengünstiger.

## Patentansprüche

1. Verfahren zur Herstellung einer elektromagnetischen Abschirmdichtung mittels einer Abschirmmasse, die eine Silikonkunststoffmasse, elektrisch leitfähige Teile sowie unter Wärmeeinfluss expandierbare Teile enthält, wobei die Abschirmmasse auf ein Gehäuse und/oder eine Leiterplatte und/oder Gehäuseteile dispensiert wird und nach und/oder bei dem Dispensieren mit Wärme behandelt wird und die dispensierte Masse dabei ihre gewünschte vorbestimmte Ausweitung und/oder Form erhält.

2. Verfahren nach Anspruch 1,
**dadurch gekennzeichnet, dass** die expandierbaren Teilchen in nicht expandiertem Zustand einen Durchmesser im wesentlichen im Bereich von 2 bis 50 µm, in expandiertem Zustand einen Durchmesser im wesentlichen im Bereich von etwa 30 bis 200 µm aufweisen.

3. Verfahren nach Anspruch 1 oder 2,
**dadurch gekennzeichnet, dass** die expandierbaren Teile Mikrokugeln bzw. Mikrohohlkugeln aus einem Polymer oder einem anderen Kunststoff sind, welche elektrisch nicht leitend und welche durch Wärmebehandlung in ihrer Größe um einen Faktor von etwa 5 bis 70 im Volumen vergrößerbar sind.

4. Verfahren nach einem der vorhergehenden Ansprüche,
**dadurch gekennzeichnet, dass** bei der Wärmebehandlung die Temperatur der Abschirmmasse etwa im Bereich von 50°C bis 140°C liegt.

5. Verfahren nach einem der vorhergehenden Ansprüche,
**dadurch gekennzeichnet, dass** nach dem Dispensieren und nach der Wärmebehandlung die Abschirmmasse im Querschnitt im wesentlichen kreisförmig (Raupe, Doppelraupe) ist.

6. Elektrisches Gerät mit einem Gehäuse und/oder einer Leiterplatte, hergestellt mit einem Verfahren nach einem der vorhergehenden Ansprüche.

7. Elektrisches Gerät nach Anspruch 6,
**dadurch gekennzeichnet, dass** das elektrische Gerät ein Empfänger, ein Mobiltelefon, ein Navigationsgerät, eine Steuerung, eine Regelung, ein Computer oder dergleichen ist.

8. Verfahren nach einem der vorhergehenden Ansprüche,
**dadurch gekennzeichnet, dass** Mittel vorgesehen sind, durch die die Ausweitung (Expansion) in eine zweckgebundene und/oder zweckmäßige Richtung und/oder Form geleitet wird.

9. Verfahren nach einem der vorhergehenden Ansprüche,
**dadurch gekennzeichnet, dass** die expansierte Abschirmmasse lokal eine unterschiedliche (partielle) Wärmebehandlung erfährt, um gezielte unterschiedliche Höhen und/oder Breiten der ausgeweiteten Abschirmmasse zu erzielen und um ggf. physikalische Deformierungskräfte zu senken.

## Claims

1. A method of producing an electromagnetic shielding seal by means of a shielding material which contains a synthetic silicone material, electrically conductive parts and parts which can expand under the influence of heat, wherein the shielding material is dispensed on to housing and/or circuit board and/or housing parts, and after and/or during the dispensing is heat-treated and the dispensed material thus achieves its desired predetermined expansion and/or shape.

2. A method according to Claim 1,
**characterised in that** in the unexpanded state the expandable particles have a diameter substantially in the range of 2 to 50 µm and in the expanded state have a diameter substantially in the range of 30 to 200 µm.

3. A method according to Claim 1 or 2,
**characterised in that** the expandable parts are microspheres or micro hollow spheres consisting of a polymer or another plastics material, which are electrically non-conductive and which by heat treatment can be enlarged in size by a factor of approximately 5 to 70 in volume.

4. A method according to any one of the preceding Claims,
**characterised in that** during the heat treatment the temperature of the shielding material lies approximately within the range of 50°C to 140°C.

5. A method according to any one of the preceding Claims,
**characterised in that** after the dispensing and after the heat treatment the shielding material is substantially circular in cross-section (bead, double bead).

6. An electrical appliance with a housing and/or a circuit board produced with a method according to any one of the preceding Claims.

7. An electrical appliance according to Claim 6,
**characterised in that** the electrical appliance is a receiver, a mobile telephone, a navigating appliance, a control means, a regulating means, a computer or the like.

8. A method according to any one of the preceding Claims,
**characterised in that** means are provided by which the widening (expansion) is directed in a specific and/or advantageous direction and/or shape.

9. A method according to any one of the preceding Claims,
**characterised in that** the expanded shielding material undergoes locally a different (partial) heat treatment so as to achieve selective different heights and/or widths of the expanded shielding material and so as to decrease any physical deforming forces.

## Revendications

1. Procédé de réalisation d'une garniture de blindage électromagnétique, au moyen d'une pâte de blindage, qui contient une pâte de matière plastique de silicone, des particules électroconductrices, ainsi que des particules expansibles sous l'effet de la chaleur, dans lequel procédé la pâte de blindage est déposée sur un boîtier et/ou une plaquette de circuits imprimés et/ou des parties du boîtier et est soumise à un traitement thermique après et/ou lors du dépôt et la pâte déposée reçoit à cette occasion sa dilatation et/ou sa forme prédéfinies souhaitées.

2. Procédé selon la revendication 1, **caractérisé en ce que** les particules expansibles ont à l'état non expansé un diamètre sensiblement dans une plage de 2 à 50 µm, ont à l'état expansé un diamètre sensiblement dans une plage de 30 à 200 µm.

3. Procédé selon la revendication 1 ou 2, **caractérisé en ce que** les particules expansibles sont des micro-billes ou micro-billes creuses en polymère ou dans une autre matière plastique, lesquelles sont non électroconductrices et dont les dimensions peuvent être augmentées par traitement thermique d'un facteur de 5 à 70 environ en volume.

4. Procédé selon l'une quelconque des revendications précédentes, **caractérisé en ce que** lors du traitement thermique la température de la pâte de blindage se situe à peu près dans la plage de 50°C à 140°C.

5. Procédé selon l'une quelconque des revendications précédentes, **caractérisé en ce que**, après le dépôt et après le traitement thermique, la pâte de blindage a une section sensiblement circulaire (chenille, double chenille).

6. Appareil électrique comportant un boîtier et/ou une plaquette de circuits imprimés, réalisé avec un procédé selon l'une quelconque des revendications précédentes.

7. Appareil électrique selon la revendication 6, **caractérisé en ce que** l'appareil électrique est un récepteur, un téléphone mobile, un appareil de navigation, une commande, un dispositif de réglage, un ordinateur ou élément similaire.

8. Procédé selon l'une quelconque des revendications précédentes, **caractérisé en ce qu'**il est prévu des moyens, par lesquels la dilatation (expansion) est guidée dans une direction et/ou une forme affectées à un usage défini et/ou appropriées.

9. Procédé selon l'une quelconque des revendications précédentes, **caractérisé en ce que** la pâte de blindage dilatée subit localement un traitement thermique (partiel) différent, pour obtenir différentes hauteurs et/ou largeurs ciblées de la pâte de blindage et pour, le cas échéant, diminuer les forces physiques de déformation.
